(19) **Europäisches Patentamt**
**European Patent Office**
**Office européen des brevets**

(11) **EP 3 281 365 B1**

(12) **EUROPÄISCHE PATENTSCHRIFT**

(45) Veröffentlichungstag und Bekanntmachung des Hinweises auf die Patenterteilung:
**18.05.2022 Patentblatt 2022/20**

(21) Anmeldenummer: **16724876.4**

(22) Anmeldetag: **19.05.2016**

(51) Internationale Patentklassifikation (IPC):
*H04L 12/40* (2006.01)     *H04L 12/10* (2006.01)
*G01R 19/00* (2006.01)

(52) Gemeinsame Patentklassifikation (CPC):
**H04L 12/40032; G01R 19/0092; H04L 12/10; H04L 12/40045; H04L 12/40169**

(86) Internationale Anmeldenummer:
**PCT/EP2016/061288**

(87) Internationale Veröffentlichungsnummer:
**WO 2016/206875 (29.12.2016 Gazette 2016/52)**

(54) **SCHNITTSTELLENERWEITERUNGSEINRICHTUNG FÜR EINE NETZWERKEINRICHTUNG UND VERFAHREN ZUM BETRIEB EINER SCHNITTSTELLENERWEITERUNGSEINRICHTUNG**

INTERFACE EXTENSION DEVICE FOR A NETWORK DEVICE AND METHOD FOR OPERATING AN INTERFACE EXTENSION DEVICE

DISPOSITIF D'EXTENSION D'INTERFACE POUR UN DISPOSITIF RÉSEAU ET PROCÉDÉ DE FONCTIONNEMENT D'UN DISPOSITIF D'EXTENSION D'INTERFACE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **22.06.2015 DE 102015211478**

(43) Veröffentlichungstag der Anmeldung:
**14.02.2018 Patentblatt 2018/07**

(73) Patentinhaber: **Siemens Aktiengesellschaft 80333 München (DE)**

(72) Erfinder:
• **ZIRKLER, Andreas**
**81735 München (DE)**
• **ARMBRUSTER, Michael**
**80339 München (DE)**

(56) Entgegenhaltungen:
**EP-A2- 1 030 185     WO-A1-2011/151773**
**US-A1- 2014 265 550**

**Beschreibung**

Die Erfindung betrifft eine Schnittstellenerweiterungseinrichtung für eine Netzwerkeinrichtung. Netzwerkeinrichtungen oder Netzwerkknoten werden in Kommunikationsnetzwerken eingesetzt und können beispielsweise Sensordaten oder Steuerdaten erzeugen und verarbeiten. Die Erfindung betrifft ferner ein Verfahren zum Betrieb einer Schnittstellenerweiterungseinrichtung an einer Netzwerkeinrichtung.

In sicherheitsrelevanten Netzwerken, wie beispielsweise in Automatisierungsanlagen oder im automobilen Fahrzeugbereich, müssen auch bei Fehlern von Hardware-Komponenten oder Übertragungswegen besonders sicherheitsrelevante Daten weiterhin übertragen werden. In derartigen sicherheitsrelevanten Netzwerken wurde bereits der Betrieb einer Mehrzahl von Netzwerkeinrichtungen vorgeschlagen, welche in einer ringförmigen Topologie verbunden sind.

Eine weitere Maßnahme zur Erhöhung der Sicherheit wird durch eine redundante Datenverarbeitung innerhalb einer Netzwerkeinrichtung gewährleistet. Eine auch als Duplex-Controller bekannte Netzwerkeinrichtung umfasst vorzugsweise parallel arbeitende Steuereinrichtungen, also parallel arbeitende Mikroprozessoren oder auch parallel arbeitende Mikroprozessorkerne eines Mehrkernprozessors, auf denen eine redundante Datenverarbeitung auf zwei getrennten Bearbeitungswegen bzw. "Execution Lanes" erfolgt. Zwei einem jeweiligen Bearbeitungsweg zugeordnete Prozesse überwachen sich gegenseitig hinsichtlich der zu- und abgeführten Daten. Im Fall einer Abweichung wird ein Fehler erkannt und die auf den beiden Bearbeitungswegen errechneten Ergebnisse werden verworfen. Eine solche Maßnahme gewährleistet ein in der Fachwelt auch als "Fail-Safe" bezeichnetes Verhalten.

Zur Gewährleistung eines strengeren "Fail-Operational"-Verhaltens kann zusätzlich vorgesehen sein, dass im Fall der oben erläuterten Abweichung eine weitere parallel arbeitende Steuereinrichtung die Steuerung übernimmt.

Netzwerkeinrichtungen der oben genannten Art kommen künftig in sicherheitsrelevanten Netzwerken, insbesondere im Fahrzeugbereich, zum Einsatz und werden derzeit im Projekt RACE (Robust and Reliable Automotive Computing Environment for Future E-Cars) fortentwickelt. Derartige Netzwerkeinrichtungen verfügen üblicherweise über eine Mehrzahl an digitalen Schnittstellen, also digitale Ein- und/oder Ausgänge, welche ihrerseits mit redundanten Sicherheitsmechanismen versehen sind.

In der Praxis zeigt sich allerdings, dass der Bedarf an digitalen Schnittstellen - z.B. zur Einbindung verschiedener Module, Sensoren und Aktoren - oftmals eine durch die Netzwerkeinrichtungen bereitgestellte Anzahl an Schnittstellen übersteigt. Ein Ausgleich dieses Mangels an Schnittstellen durch Hinzufügung zusätzlicher Netzwerkeinrichtungen und Nutzung der digitalen Schnittstellen dieser zusätzlichen Netzwerkeinrichtungen scheitert oftmals an Kostengründen.

Ferner ist es zur Optimierung eines Kabelbaums in einem Fahrzeug oftmals gewünscht, mehrere Schnittstellenbaugruppen bzw. "IO-Baugruppen" (Input / Output) in einem Fahrzeug zu verteilen und so nur kurze Kabelverbindungen zwischen Schnittstellenbaugruppen und daran angeschlossene Einheiten vorsehen zu müssen. Auch hier gilt, dass eine Hinzufügung zusätzlicher Netzwerkeinrichtungen einen vorgegebenen Kostenrahmen sprengen würde.

Eine Verwendung handelsüblicher Schnittstellenbaugruppen, beispielsweise durch einen Multiplexbetrieb mehrerer Schnittstellenbaugruppen an einer Schnittstelle einer Netzwerkeinrichtung, ist demgegenüber nicht mit dem Gesamtsicherheitskonzept des Netzwerks vereinbar, da handelsübliche Schnittstellenbaugruppen ohne Vorsehung zusätzlicher Maßnahmen nicht geeignet sind, die oben erwähnten Sicherheitsmechanismen zu gewährleisten.

Das Dokument US 2014/0265550 A1 offenbart ein Sensornetz, in dem eine Kette von Sensoren mit einer Sensorschnittstelleneinheit verbunden ist. Ein jeweiliger Sensor wird dabei über einen PoE-Anschluss sowohl mit Strom als auch mit Daten versorgt. Die Erkennung eines Fehlerfalls wird in den jeweiligen Sensoren durchgeführt.

Das Dokument WO 2011/151773 A1 offenbart einen PoE-Switch, der einen PoE-Eingangsanschluss und mehrere PoE-Ausgangsanschlüsse aufweist. Über den PoE-Eingangsanschluss wird der PoE-Switch mit Strom und Daten versorgt.

Das Dokument EP 1 030 185 A2 offenbart ein Stromversorgungssystem, in dem mehrere Verbraucher mit einem Leistungsbus zur Stromversorgung und mit einem Steuerbus zur Steuerung verbunden sind. Dabei wird ein Gesamtstrom auf dem Leistungsbus gemessen, diese Messinformation in den Steuerbus übertragen und die sich bei Schaltvorgängen ergebenden Stromdifferenzen ausgewertet.

Es ist daher eine Aufgabe der vorliegenden Erfindung, eine Schnittstellenerweiterungseinrichtung zu schaffen, welche über Sicherheitsmechanismen eines sicherheitsrelevanten Netzwerks, beispielsweise der eingangs genannten Art, verfügt.

Die Aufgabe wird erfindungsgemäß durch eine Anzeigevorrichtung mit den Merkmalen des Patentanspruchs 1 gelöst.

Die erfindungsgemäße Schnittstellenerweiterungseinrichtung basiert auf einer Netzwerkeinrichtung mit mindestens einem zuvor unbelegten digitalen Datenausgang, an die eine Schnittstellenerweiterungsbaugruppe mit mindestens einem Versorgungsspannungseingang und mit einer Mehrzahl digitaler Erweiterungsschnittstellen in der erfindungsgemäßen Weise gekoppelt wird. Dabei ist vorgesehen, den Versorgungsspannungseingang der Schnittstellenerweiterungsbaugruppe mit dem digitalen Datenausgang der Netzwerkeinrichtung zu verschalten, so dass in einem durch die Netzwerkeinrichtung erkannten Fehlerfall die Schnittstellenerweiterungsbaugruppe mit all deren Erweiterungsschnittstellen abschaltbar ist.

Die erfindungsgemäße Verschaltung des Versorgungsspannungseingangs der Schnittstellenerweiterungsbaugruppe mit dem digitalen Datenausgang der Netzwerkeinrichtung hat den Vorteil, ein Fail-Safe-Verhalten auch für herkömmliche Schnittstellenerweiterungsbaugruppen zu implementieren. In einem durch die Netzwerkeinrichtung erkannten Fehlerfall können durch die redundanten Sicherheitsmechanismen der Netzwerkeinrichtung auch die Erweiterungsschnittstellen der Schnittstellenerweiterungsbaugruppe sicher abgeschaltet werden. Durch das Abschalten des Datenausgangs, welcher erfindungsgemäß die Versorgungsspannung der Schnittstellenerweiterungsbaugruppe liefert, werden alle Schnittstellen, insbesondere Ausgänge, der Schnittstellenerweiterungsbaugruppen abgeschaltet. Diese Abschaltung ist insbesondere auch dann gewährleistet, falls die Schnittstellenerweiterungsbaugruppe selbst defekt sein sollte. Damit gewährleistet die erfindungsgemäße Schnittstellenerweiterungseinrichtung die geforderten Sicherheitsmechanismen des sicherheitsrelevanten Netzwerks.

Die Aufgabe wird weiterhin durch ein erfindungsgemäßes Verfahren mit den Merkmalen des Patentanspruchs 2 gelöst.

Durch das gleichzeitige Abschalten aller Erweiterungsschnittstellen der Schnittstellenerweiterungsbaugruppe wird zwar noch keine optimale Verfügbarkeit der Erweiterungsschnittstellen im Sinne eines Fail-Operational-Verhaltens gewährleistet, jedoch kann ein sicherer Fail-Safe-Zustand in einem Fehlerfall garantiert werden.

Falls für einzelne Erweiterungsschnittstellen ein Fail-Operational-Verhalten im Fehlerfall gefordert ist, werden die Erweiterungsschnittstellen gemäß einer alternativen Ausführungsform redundant vorgehalten. Eine redundante Gestaltung der Erweiterungsschnittstellen erfolgt in der Weise, dass die bezüglich einer ersten Erweiterungsschnittstelle redundante zweite Erweiterungsschnittstelle über eine zweite mit der erfindungsgemäßen Schnittstellenerweiterungseinrichtung erweiterten Netzwerkeinrichtung angesteuert werden.

Weitere vorteilhafte Ausgestaltungen der Erfindung sind Gegenstand der abhängigen Ansprüche.

Gemäß einer Ausgestaltung der Erfindung ist vorgesehen, eine dem Datenausgang der Netzwerkeinrichtung zugeordnete Lastdiagnoseeinrichtung zur Messung eines Summenstroms aller über den digitalen Datenausgang der Netzwerkeinrichtung fließenden Teilströme der Erweiterungsschnittstellen der Schnittstellenerweiterungsbaugruppe zu verwenden. Diese Maßnahme gestattet es, die Möglichkeiten einer für Datenausgänge der Netzwerkeinrichtung implementierten Lastdiagnose auch für die Erweiterungsschnittstellen, insbesondere für die Datenausgänge der Schnittstellenerweiterungsbaugruppe, zu eröffnen.

Eine Lastdiagnose gewährleistet eine Erkennung einer Unterbrechung der Leitungsverbindung zu einer am Datenausgang angeschlossenen Last oder einen Kurzschluss des Datenausgangs, an den die Last angeschlossen ist, gegen ein Versorgungspotential oder gegen ein Bezugspotential zu erkennen. Darüber hinaus kann mit der Lastdiagnose der über den Datenausgang fließende Strom zu Diagnosezwecken gemessen werden.

Mit einem erfindungsgemäßen Anschluss der Erweiterungsbaugruppe ist es nun möglich, eine Lastdiagnose über alle Erweiterungsschnittstellen der Schnittstellenerweiterungsbaugruppe durchzuführen. Obgleich die Lasten an jeder einzelnen Erweiterungsschnittstelle nicht unabhängig erfasst werden können, gestattet eine Erfassung einer Gesamtlast über die Summe der fließenden Ströme Rückschlüsse auf die Last jeder einzelnen Erweiterungsbaugruppe:

- Zum einen muss das Schalten eines Datenausgangs der Erweiterungsbaugruppe in jedem Fall zu einer Veränderung der Summe der fließenden Ströme führen, so dass eine Lastdiagnose auch Rückschlüsse auf die Last einzelner Datenausgänge der Erweiterungsschnittstellen gewährt.

- Weiterhin lässt eine Messung des Verbauchs der gesamten Erweiterungsbaugruppe Rückschlüsse auf einzelne Erweiterungsschnittstellen zu, indem die folgende Beziehung für die Gesamtleistung Pgesamt aufgelöst wird:

$$P_{gesamt} = P_{modul} + \eta \sum_{1}^{n} Schaltzustand_n * P_n$$

Dabei bezeichnen:

$P_{modul}$ = Eigenverbrauch der Erweiterungsbaugruppe
$n$ = Anzahl ausgehender Erweiterungsschnittstellen
$\eta$ = Wirkungsgrad ausgehender Erweiterungsschnittstellen
$Schaltzustand_n$ = {ein|aus}

$P_n$= Leistung der an der Erweiterungsschnittstelle n angeschlossenen Last

Abweichungen von dieser Bedingung lassen auf den Defekt einer Last schließen. Weiterhin kann durch kurzzeitiges Schalten einzelner Erweiterungsschnittstellen gezielt diagnostiziert werden, welche Erweiterungsschnittstelle bzw. welche an die jeweilige Erweiterungsschnittstelle angeschlossene Last defekt ist, falls dies nicht schon mit obiger Formel durch unterschiedliche Stromaufnahmen der verschiedenen Lasten oder die sich aus dem Betrieb ergebenden Schaltvorgänge erkannt werden kann.

Im Folgenden werden weitere Ausführungsbeispiele und Vorteile der Erfindung anhand der Zeichnung näher erläutert. Dabei zeigen:

Fig. 1: eine schematische Darstellung einer ersten Ausführungsform einer Schnittstellenerweiterungseinrichtung; und;

Fig. 2: eine schematische Darstellung einer zweiten Ausführungsform einer Schnittstellenerweiterungseinrichtung.

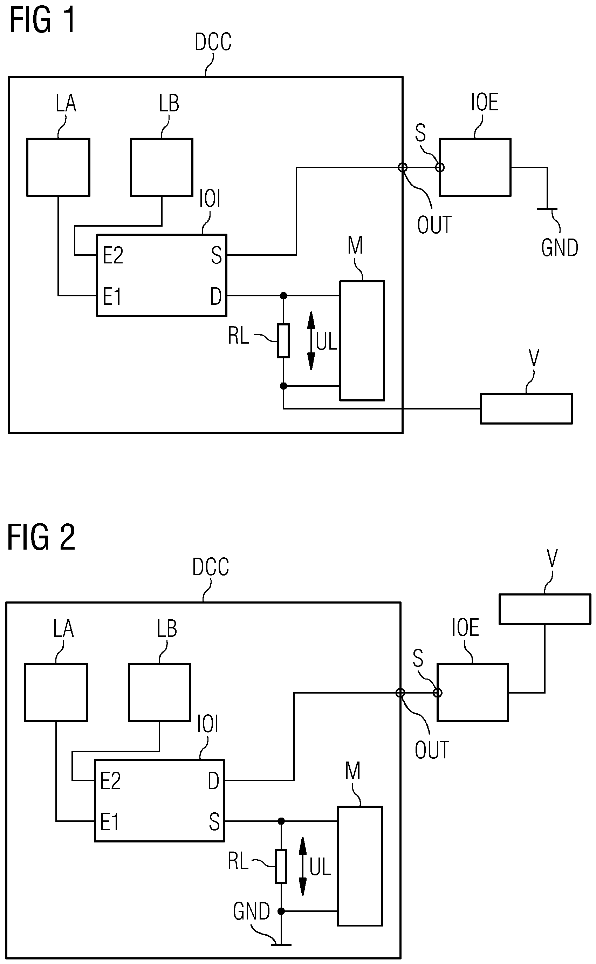

Fig. 1 zeigt eine erste Ausführungsform einer Schnittstellenerweiterungseinrichtung. Eine auch als Duplex-Controller bekannte Netzwerkeinrichtung DCC umfasst in diesem Ausführungsbeispiel parallel arbeitende - nicht dargestellte - Steuereinrichtungen, also parallel arbeitende Mikroprozessoren oder auch parallel arbeitende Mikroprozessorkerne eines Mehrkernprozessors, auf denen eine redundante Datenverarbeitung auf zwei getrennten Bearbeitungswegen LA,LB bzw. "Execution Lanes" erfolgt.

Ein erster Bearbeitungsweg LA ist zumindest vorübergehend mit einem ersten Steuereingang E1 ("Enable") eines Netzwerkeinrichtungs-internen Schnittstellenmoduls IOI verbunden. Ein zweiter Bearbeitungsweg LB ist zumindest vorübergehend mit einem zweiten Steuereingang E2 des Netzwerkeinrichtungsinternen Schnittstellenmoduls IOI verbunden.

Für das Schnittstellenmodul IOI ist aus Übersichtsgründen lediglich ein Lastanschlussklemmenpaar S,D dargestellt, wobei eine erste Lastanschlussklemme S als digitaler Datenausgang OUT der Netzwerkeinrichtung DCC nach außen geführt wird. Die erste Lastanschlussklemme S entspricht beispielsweise einem Source-Anschluss eines Halbleiterleistungsschalters. Eine zweite Lastanschlussklemme D ist in dieser Konfiguration über einen Lastwiderstand RL mit dem Versorgungspotential V einer Spannungsversorgung verbunden. Die zweite Lastanschlussklemme D entspricht beispielsweise einem Drain-Anschluss eines Halbleiterleistungsschalters.

Alle digitalen Datenausgänge der Netzwerkeinrichtung DCC - wobei aus Übersichtsgründen lediglich ein Datenausgang OUT zeichnerisch dargestellt ist - werden über das Schnittstellenmodul IOI von beiden redundanten Bearbeitungswegen LA,LB der Netzwerkeinrichtung angesteuert, wobei lediglich eine Ansteuerung der redundanten Steuereingänge E1,E2 über beide Bearbeitungswege LA,LB zum Schalten eines so angesteuerten Ausgangs OUT führt. Optional kann vorgesehen sein, dass ein so angesteuerter Ausgang zweikanalig zurückgelesen wird, um den Schaltzustand sicher erkennen zu können.

Eine weitere Maßnahme zur Erhöhung der Sicherheit gemäß einer vorteilhaften Ausgestaltung der Erfindung wird durch eine Lastanalyse des digitalen Datenausgangs OUT gewährleistet. Bei einer solchen Lastdiagnose wird der durch den Datenausgang OUT fließende Strom gemessen, um zu erkennen, ob eine daran angeschlossene Last in korrekter Weise arbeitet. Entsprechende Sicherungsmaßnahmen sind auch eingangsseitig an - nicht dargestellten - digitalen Eingängen der Netzwerkeinrichtung DCC vorgesehen. Hierzu wird ein digitaler Eingang zweikanalig eingelesen. Auf diese Weise ist es möglich, Fehler mit sehr hoher Wahrscheinlichkeit zu erkennen, ein ungewolltes Einschalten von Verbrauchern im Sinne einer Fail-Safe-Maßnahme sicher auszuschließen und/oder einen defekten Verbraucher zu erkennen. Letzteres ist Voraussetzung zur Fehlererkennung und einer geeigneten Fehlerreaktion.

Eine Lastdiagnoseeinrichtung M ist parallel zum Lastwiderstand RL geschaltet und gewährleistet eine Erkennung einer Unterbrechung der Leitungsverbindung zu einer am Datenausgang OUT angeschlossenen Last oder einen Kurzschluss des Datenausgangs OUT, an den die Last angeschlossen ist, gegen ein Bezugspotentials GND ("Ground") bezüglich des Versorgungspotentials V. Darüber hinaus kann mit der Lastdiagnoseeinrichtung M des durch den Datenausgang OUT fließenden Stroms durch Messung einer am Lastwiderstand RL abfallenden elektrischen Spannung UL ermittelt werden. Optional kann vorgesehen sein, dass die Lastdiagnoseeinrichtung zweikanalig ausgeführt ist.

Erfindungsgemäß wird eine Schnittstellenerweiterungsbaugruppe IOE dahingehend an die Netzwerkeinrichtung DCC angeschlossen, dass der Versorgungsspannungseingang S der Schnittstellenerweiterungsbaugruppe IOE nicht, wie im Stand der Technik üblich, an das Versorgungspotential V der Spannungsversorgung, in Fahrzeugen beispielsweise Klemme 15 oder Klemme 30, angeschlossen wird, sondern an den digitalen Datenausgang OUT der Netzwerkeinrichtung DCC. Die einzelnen Schnittstellenports, also digitale Ein- und/oder Ausgänge, der Schnittstellenerweiterungsbaugruppe IOE sind aus Übersichtsgründen zeichnerisch nicht dargestellt.

In der in Fig. 1 dargestellten Auslegung liegt eine am digitalen Datenausgang OUT angeschlossene Last - welche gemäß der erfindungsgemäßen Anordnung durch die Schnittstellenerweiterungsbaugruppe IOE gebildet wird - zwischen der ersten Lastanschlussklemme S des Halbleiterleistungsschalters und dem Bezugspotential GND. Eine solche Auslegung ist in der Fachwelt auch als High-Side-Schalter bekannt.

Die weitere Figurenbeschreibung erfolgt unter weiterer Bezugnahme auf die Funktionseinheiten der Figur 1. Identische Bezugszeichen in verschiedenen Figuren repräsentieren hierbei identische Funktionseinheiten.

Eine alternative Auslegung des digitalen Datenausgangs OUT zeigt Fig. 2. In der in Fig. 2 dargestellten Auslegung liegt eine am digitalen Datenausgang OUT angeschlossene Last - welche gemäß der erfindungsgemäßen Anordnung durch die Schnittstellenerweiterungsbaugruppe IOE gebildet wird - zwischen einer zweiten Lastanschlussklemme D des Halbleiterleistungsschalters und dem Versorgungspotential V. Eine solche Auslegung ist in der Fachwelt auch als Low-Side-Schalter bekannt.

Auch in der Auslegung des digitalen Datenausgangs OUT als Low-Side-Schalter gemäß Fig. 2 ist eine Lastdiagnoseeinrichtung M parallel zum Lastwiderstand RL geschaltet. Die Lastdiagnoseeinrichtung M gewährleistet eine Erkennung einer Unterbrechung der Leitungsverbindung zu einer am Datenausgang OUT angeschlossenen Last oder einen Kurzschluss des Datenausgangs OUT, an den die Last angeschlossen ist, gegen das Versorgungspotentials V. Weiterhin wird über die Lastdiagnoseeinrichtung M des durch den Datenausgang OUT fließenden Stroms durch Messung einer am Lastwiderstand RL abfallenden elektrischen Spannung UL ermittelt.

Abgesehen von den oben dargestellten Unterschieden in der Auslegung des Datenausgangs OUT entspricht die in Fig. 2 dargestellte zweite Ausführungsform der in Fig. 1 dargestellten ersten Ausführungsform der Schnittstellenerweiterungseinrichtung und ist zu dieser funktional identisch.

Wenngleich die redundante Datenverarbeitung innerhalb der Netzwerkeinrichtung DCC, also insbesondere die redundanten Bearbeitungswege LA,LB sowie eine Implementierung parallel arbeitende Mikroprozessoren oder auch parallel arbeitende Mikroprozessorkerne eines Mehrkernprozessors zur erfindungsgemäßen Aufgabe geführt haben, diese Sicherheitsmaßnahmen auch auf die erfindungsgemäß geschaffene Schnittstellenerweiterungseinrichtung zu erweitern, ist die Erfindung selbstverständlich nicht auf die in diesem Ausführungsbeispiel beschriebene Implementierung der Netzwerkeinrichtung als Duplex Controller beschränkt. Die erfindungsgemäßen Mittel gestatten ohne weiteres auch einen Einsatz in nicht-redundant ausgelegten Netzwerkeinrichtungen jeglicher Art, beispielsweise auf Basis eines einzelnen Mikrocontrollers.

**Patentansprüche**

1. Anordnung zur Schnittstellenerweiterung, umfassend:

   - eine Netzwerkeinrichtung (DCC); welche zumindest einen digitalen Datenausgang (OUT) aufweist und;
   - eine Schnittstellenerweiterungseinrichtung umfassend eine Schnittstellenerweiterungsbaugruppe (IOE) mit mindestens einem Versorgungsspannungseingang (S), **gekennzeichnet durch**,
   - die Schnittstellenerweiterungsbaugruppe (IOE) umfassend eine Mehrzahl an Erweiterungsschnittstellen;
   - eine Verschaltung des mindestens einen Versorgungsspannungseingangs (S) der Schnittstellenerweiterungsbaugruppe (IOE) mit einem digitalen Datenausgang (OUT) der Netzwerkeinrichtung (DCC), so dass in einem durch die Netzwerkeinrichtung (DCC) erkannten Fehlerfall die Schnittstellenerweiterungsbaugruppe (IOE) mit all deren Erweiterungsschnittstellen abschaltbar ist; und;
   - eine dem Datenausgang (OUT) der Netzwerkeinrichtung (DCC) zugeordnete Lastdiagnoseeinrichtung (M) zur Messung eines Summenstroms aller über den digitalen Datenausgang (OUT) der Netzwerkeinrichtung (DCC) fließenden Teilströme der Erweiterungsschnittstellen der Schnittstellenerweiterungsbaugruppe (IOE).

2. Verfahren zum Betrieb einer Schnittstellenerweiterungseinrichtung für eine Netzwerkeinrichtung (DCC), welche mindestens einen digitalen Datenausgang (OUT) aufweist, die Schnittstellenerweiterungseinrichtung ferner umfassend eine Schnittstellenerweiterungsbaugruppe (IOE) mit mindestens einem Versorgungsspannungseingang (S) und die Schnittstellenerweiterungsbaugruppe (IOE) umfassend eine Mehrzahl an Erweiterungsschnittstellen, **dadurch gekennzeichnet,**

   - **dass** der mindestens eine Versorgungsspannungseingang (S) der Schnittstellenerweiterungsbaugruppe (IOE) mit einem digitalen Datenausgang (OUT) der Netzwerkeinrichtung (DCC) verschaltet wird;
   - **dass** in einem durch die Netzwerkeinrichtung (DCC) erkannten Fehlerfall die Schnittstellenerweiterungsbaugruppe (IOE) mit all deren Erweiterungsschnittstellen abgeschaltet wird; und;
   - **dass** mit einer dem Datenausgang (OUT) der Netzwerkeinrichtung (DCC) zugeordneten Lastdiagnoseeinrichtung (M) ein Summenstrom aller über den digitalen Datenausgang (OUT) der Netzwerkeinrichtung (DCC) fließenden Teilströme der Erweiterungsschnittstellen gemessen wird.

**3.** Verfahren gemäß Patentanspruch 2,
**dadurch gekennzeichnet,**
**dass** ein besagter Fehlerfall erkannt wird, sofern bei einem Schalten mindestens einer ausgehenden Erweiterungsschnittstelle der Schnittstellenerweiterungsbaugruppe (IOE) keine Veränderung des Summenstroms gemessen wird.

**4.** Verfahren gemäß einem der Patentansprüche 2 und 3,
**dadurch gekennzeichnet,**
**dass** ein besagter Fehlerfall erkannt wird, sofern der mittels der Lastdiagnoseeinrichtung gemessene Summenstrom nicht mit einem erwarteten Summenstrom aller über den digitalen Datenausgang (OUT) der Netzwerkeinrichtung (DCC) fließenden Teilströme übereinstimmt.

**Claims**

**1.** An arrangement for interface expansion, comprising:

- a network device (DCC); which has at least one digital data output (OUT) and;
- an interface expansion device comprising an interface expansion module (IOE) having at least one supply voltage input (S), **characterized by**

- the interface expansion module (IOE) comprising a plurality of expansion interfaces;
- an interconnection of the at least one supply voltage input (S) of the interface expansion module (IOE) with a digital data output (OUT) of the network device (DCC), with the result that, in the event of a fault identified by the network device (DCC), the interface expansion module (IOE) with all of the expansion interfaces thereof can be disconnected; and;
- a load diagnosis device (M), which is associated with the data output (OUT) of the network device (DCC), for measuring a summation current of all the partial currents of the expansion interfaces of the interface expansion module (IOE) that flow via the digital data output (OUT) of the network device (DCC).

**2.** Method for operating an interface expansion device for a network device (DCC), which has at least one digital data output (OUT), the interface expansion device further comprising an interface expansion module (IOE) having at least one supply voltage input (S) and the interface expansion module (IOE) comprising a plurality of expansion interfaces, **characterized in that**

- the at least one supply voltage input (S) of the interface expansion module (IOE) is interconnected with a digital data output (OUT) of the network device (DCC);
- in the event of a fault identified by the network device (DCC), the interface expansion module (IOE) with all of the expansion interfaces thereof is disconnected; and;
- a summation current of all the partial currents of the expansion interfaces that flow via the digital data output (OUT) of the network device (DCC) is measured using a load diagnosis device (M), which is associated with the data output (OUT) of the network device (DCC).

**3.** Method according to Patent Claim 2,
**characterized in that**
an aforesaid fault event is identified if no change in the summation current is measured when switching at least one outgoing expansion interface of the interface expansion module (IOE) .

**4.** Method according to either of Patent Claims 2 and 3,
**characterized in that**
an aforesaid fault event is identified if the summation current measured by means of the load diagnosis device does not correspond to an expected summation current of all the partial currents that flow via the digital data output (OUT) of the network device (DCC).

**Revendications**

**1.** Dispositif d'extension d'interface, comprenant :

- un dispositif réseau (DCC) ; lequel présente au moins une sortie de données numérique (OUT) et ;
- un dispositif d'extension d'interface comprenant un bloc d'extension d'interface (IOE) avec au moins une entrée de tension d'alimentation (S), **caractérisé par**

- le bloc d'extension d'interface (IOE) comprenant une pluralité d'interfaces d'extension ;
- un câblage d'au moins une entrée de tension d'alimentation (S) du bloc d'extension d'interface (IOE) avec une sortie de données numériques (OUT) du dispositif réseau (DCC), de sorte qu'en cas d'erreur reconnu par le dispositif réseau (DCC), le bloc d'extension d'interface (IOE) avec toutes ses extensions d'interface peut être déconnecté ; et
- un dispositif de diagnostic de charge (M) affecté à la sortie de données (OUT) du dispositif réseau (DCC) pour mesurer un courant cumulé de tous les courants partiels des interfaces d'extension du bloc d'extension d'interface (IOE), circulant par la sortie de données numérique (OUT) du dispositif réseau (DCC).

2. Procédé de fonctionnement d'un dispositif d'extension d'interface pour un dispositif réseau (DCC), lequel présente au moins une sortie de données numérique (OUT), le dispositif d'extension d'interface comprenant, en outre, un bloc d'extension d'interface (IOE) avec au moins une entrée de tension d'alimentation (S) et le bloc d'extension d'interface (IOE) comprenant une pluralité d'interfaces d'extension, **caractérisé**

- **en ce que** la au moins une entrée de tension d'alimentation (S) du bloc d'extension d'interface (IOE) est connectée à une sortie de données numérique (OUT) du dispositif réseau (DCC) ;
- **en ce qu'**en cas d'erreur reconnu par le dispositif réseau (DCC), le bloc d'extension d'interface (IOE) avec toutes ses extensions d'interface est déconnecté ; et
- **en ce qu'**avec un dispositif de diagnostic de charge (M) affecté à la sortie de données (OUT) du dispositif réseau (DCC), un courant cumulé de tous les courants partiels des interfaces d'extension, circulant par la sortie de données numérique (OUT) du dispositif réseau (DCC) est mesuré.

3. Procédé selon la revendication 2, **caractérisé en ce qu'**un cas d'erreur susmentionné est reconnu dans la mesure où, lors d'une connexion d'au moins une interface d'extension sortante du bloc d'extension d'interface (IOE), aucune modification du courant cumulé n'est mesurée.

4. Procédé selon l'une des revendications 2 et 3, **caractérisé en ce qu'**un cas d'erreur susmentionné est reconnu dans la mesure où le courant cumulé mesuré à l'aide du dispositif de diagnostic de charge ne concorde pas avec un courant cumulé escompté de tous les courants partiels circulant par la sortie de données numérique (OUT) du dispositif réseau (DCC).

# FIG 1

DCC

LA        LB

IOI

E2    S

E1    D

IOE

S

OUT

GND

M

RL   UL

V

# FIG 2

DCC

LA        LB

IOI

E2    D

E1    S

V

IOE

S

OUT

M

RL   UL

GND

**IN DER BESCHREIBUNG AUFGEFÜHRTE DOKUMENTE**

**In der Beschreibung aufgeführte Patentdokumente**

- US 20140265550 A1
- WO 2011151773 A1
- EP 1030185 A2